# EUROPÄISCHE PATENTANMELDUNG

(11) **EP 1 696 404 A1**
(43) Veröffentlichungstag der Anmeldung: **30.08.2006**
(21) Anmeldenummer: 05004181.3
(22) Anmeldetag: 25.02.2005
(51) Int. Cl.: G09F 9/33

(54) **Leuchtdiodenanordnung**

(71) Anmelder: Electrovac, Fabrikation elektrotechnischer Spezialartikel Gesellschaft m.b.H., 3400 Klosterneuburg (AT)
(72) Erfinder: Reiter, Werner, Dipl.-Ing., 1030 Wien (AT); Grinninger, Uwe, Dipl.-Ing., 4784 Schardenberg (AT)
(74) Vertreter: Gibler, Ferdinand

(57) **Zusammenfassung**

Bei einer Leuchtdiodenanordnung (1), umfassend wenigstens eine auf einer Leiterplatte (2), vorzugsweise auf Basis von Kunstharz und Glasfasern, angeordnete und kontaktierte Leuchtdiode (3), vorzugsweise wenigstens eine SMD- Leuchtdiode (4), wird zur Verringerung der Bauhöhe bei einer gleichmäßigen Lichtabstrahlung bzw. Ausleuchtung einer Fläche sowie einer Verbesserung der automatisierten Fertigung vorgeschlagen, dass die Abstrahlfläche (5) der Leuchtdiode (3) der Leiterplatte (2) zugewandt ist, wobei der mit der Abstrahlfläche (5) zusammenwirkende Teil (6) der Leiterplatte (2) in Abstrahlrichtung der Leuchtdiode (3) zumindest bereichsweise transluzent ist.

## Beschreibung

Die Erfindung betrifft eine Leuchtdiodenanordnung umfassend wenigstens eine auf einer Leiterplatte, vorzugsweise auf Basis von Kunstharz und Glasfasern, angeordnete und kontaktierte Leuchtdiode, vorzugsweise wenigstens eine SMD-Leuchtdiode.

LED Anzeigen sind Stand der Technik zur Funktions- und Statusanzeige in u.a. elektrischen Geräten, Reklamepaneelen, Signalleuchten und Effektbeleuchtungskörpern. In großen Stückzahlen hergestellt, werden sie sowohl einzeln als auch in flächig oder strangartig assemblierten Einheiten angeboten. Verbunden mit einer Schalt- und Recheneinheit lassen sich somit Zahlen, Texte und Symbole beliebig darstellen und in Anzeigenpaneele elektronischer Geräte integrieren. Die Formvielfalt bzw. die Ausgestaltung der gewünschten Leuchtanzeige ist nunmehr eine Frage des Preises und der Designwünsche.

Die Leuchtdiode, auch LED (Light Emitting Diode) genannt, ist eine Halbleiterdiode, die beim Betrieb in Durchlassrichtung Licht erzeugt. Dabei gibt ein Halbleiterkristall ein Lichtsignal ab, das durch die linsenförmige Form des Kopfes gebündelt bzw. gestreut wird. Leuchtdioden gibt es in verschiedenen Farben, Größen und Bauformen. Deshalb werden sie u.a. auch als Signallampen verwendet. Dieses Bauteil ist je nach Farbe aus unterschiedlichen Halbleiterkristallen aufgebaut. Sie funktioniert dabei wie jede andere Halbleiterdiode auch. Als Bauteil lässt sie sich in einfacher Weise auf strukturierte Leiterplatten (PCBs) bzw. Träger montieren und kontaktieren, was je nach Ausgestaltung und technischem Bedürfnis durch stecken, kleben, löten etc. ezfolgen kann.

LED Anzeigen werden sowohl als Einzellampen zur einfachen Ein/Aus Statusanzeige als auch als komplexe Displays, wobei LED Chips rasterartig angeordnet sind, gebaut und eingesetzt.

Effektbeleuchtungskörper und Leuchtreklamen werden mittlerweile aus Platz und Konstruktionsgründen gerne mit LEDs als Lichtquelle gefertigt. Als mögliche Ausführungsform sei hier die Gebrauchsmusterschrift DE20012380U1 angegeben. In diesem Beispiel sind LED Chips auf ein PCB (Printed Circuit Board) aufgesetzt und diese Einheit in ein Gebäuse integriert. Das Gehäuse selbst umfasst eine hintere Reflektorwand auf welche die Lichtquelle gerichtet ist und eine transparente Frontschale. Wie unschwer nachzuvollziehen, ist dieser Aufbau geeignet ein homogenes Lichtband bzw. homogen ausgeleuchtete Flächen zu erzeugen. Flache und kompakte LED Anzeigen in elektronischen Geräten und Funktionskomponenten sind mittlerweile Stand der Technik, mit dem Ziel, sowohl optische Annehmlichkeit als auch den Funktionsstatus des Gerätes zu vermitteln. Speziell aus designtechnischen Gründen ist es wünschenswert Leuchtanzeigen in kompakter, möglichst miniaturisierter Form vorzusehen- Eine gebräuchliche Art solcher Lichtemissions-Anzeigevorrichtungen ist in der DE3633203A1 angegeben. Ausgehend von einer auf ein Substrat montierten LED wird mittels strukturierten Lichtleitelementen die Kontur, bzw. flächige Darstellung von Zeichen realisiert. Dabei ist für jedes individuelle Zeichen zumindest ein LED Chip von Nöten. Diese vorgeschlagene Anzeigeeinheit erlaubt eine flache und kompakte Konstruktion, bedingt jedoch die nach innen gerichtete Verspiegelung um bestmögliche Lichtausbeute und Strukturierung der lichtverteilenden Einheit zu erreichen. Dieser Verarbeitungsschritt ist für jedes Zeichen mehr oder minder individuell vorzunehmen, was zu erheblichem Aufwand bei der Herstellung und beim Assemblieren der LED-Anzeigen führt.

Dem Integrieren von LEDs in Schaltungen und diversen Substratmaterialien, was auch der Positionierung und Befestigung dient, wird verfahrenstechnisch große Bedeutung zugemessen, da dies im Fertigungsprozess sowohl einen entscheidenden Kostenfaktor bedingt, als auch auf die Lebensdauer entscheidenden Einfluss nimmt. Integrierte LEDs, oft auch als SMD (Surface Mounted Device)-LED bezeichnet, sind konstruktiv zumeist insofern verwirklicht, als der LED Chip direkt zwischen den Strom führenden Elektroden, welche auf einer Leiterplatte vorgesehen sind, aufgesetzt wird. Die Kontaktierung des Chips mit den Elektroden erfolgt im Regelfall durch Löten. Zur Verbesserung der Befestigung wird die so angeschlossene Leuchtdiode oft mittels Kunststoff oder Epoxidharz vergossen, wobei darauf noch Linsen zur Fokussierung, bzw. Streuung des austretenden Lichtes, auf dieser Vergussschichte angebracht werden können. Eine dieser Idee folgende Konstruktion einer integrierten LED Lampe ist in der ÜS6252350 dargelegt. Eine ähnliche Struktur schlägt die Anmeldung US20040099875A1 vor, wobei der LED Chip in einer verspiegelten Vertiefung der Leiterplatte positioniert und dieser wiederum mit Epoxidharz vergossen ist. Weitere Vorschläge LEDs in Leiterplatten zu integrieren sind in den Patentschriften DE10055680 und US6562642B2 beschrieben. Beide offenbaren Lösungen, LEDs mittels in der Leiterplatte integrierten Elektroden zu kontaktieren. Um dem Anspruch nach flacher und kompakter Konstruktion Rechnung zu tragen umfasst die Leiterplatte eine Vertiefung, welche mitteilungsgemäß die LED aufzunehmen vermag. Hinter oder auf ein, gegebenenfalls mittels Distanzhalter, lichtdurchlässiges Paneel aufgebracht, welches zumeist auf der Innenseite noch eine Schatteumaske zur Symboldarstellung umfasst, können derartig erzeugte Leuchtelemente zur Funktionsanzeige in elektronischen Geräten genutzt werden.

Funktionsanzeigen in z.B. Haushaltsgeräten sind naturgemäß relativ einfach konzipiert und umfassen im Regelfall punktförmige Ein/Aus-Indikation des Betriebszustandes, bzw. wird dieser durch Buchstabenkürzel oder ein Wort in Leuchtschriftausführung als Statusanzeige wiedergegeben. In vielen Fällen ist die Notwendigkeit nach bestmöglicher Miniaturisierung solcher Anzeigen nicht zwingend gegeben. Aus diesem Grund werden in solchen Anwendungen LED Anzeigen zumeist einfach auf Halterungen bzw. Leiterplatten montiert. Dies kann durch Stecken und anschließendes Kontaktieren durch Löten geschehen. Solche LED Anzeigen werden schon als fertige SMD-Komponenten mit vordefiniertem Leuchtsymbol, wie z.B. Zahl, Buchstabe oder anderes einfaches technisches Symbol, angeboten. In gewünschter Weise auf einer Leiterplatte assembliert ergibt sich daraus hinter einer lichttransparenten Abdeckplatte die Funktionsanzeige, wobei, bedingt durch die Abmessungen der darauf aufgesetzten LED Bauteile, die Displayeinheit Dicken von bis zu einem cm und mehr erreichen können. Nachteilig ist bei derartigen Konstruktionen, dass es während des Einbaus im Endgerät, bzw. wäbrend der Assemblierung zur nächst höheren Komponente, sehr leicht zu Beschädigungen der LED Kontaktierungen kommen kann. Auch bedarf es eines gewissen fertigungstechnischen Aufwands, einzelne LEDs in der gewünschten Präzision auf der Leiterplatte zu platzieren.

Im Speziellen sind LED beleuchtete Displays bzw. Funktionsanzeigen für Keramikkochfelder sehr gut geeignet. Die US6376809 beschreibt ein Keramikkochfeld mit Leuchtanzeigesymbolen, wobei zu jeder Leuchtanzeige eine Betätigungseinheit, beschrieben in z.B. EP0802500A2, zugeordnet ist. Erfindungsgemäß umfasst die Anzeige eine Leiterplatte auf welcher Leuchtelemente angebracht sind. Diese ist direkt unter dem Keramikkochfeld montiert, wobei die Symboldarstellung durch eine Schattenmaske, welche direkt auf das Leuchtelement aufgebracht ist, gelöst ist. Die gleiche Aufgabenstellung behandelt auch die US6794621, jedoch wird hier die Symboldarstellung durch das Aufbringen einer lichtundurchlässigen Schicht auf der Kochfeldunterseite, welche direkt über dem Leuchtelement unterbrochen ist, erzeugt.

Die Bauhöhe einer derartigen Komponente durch Einsatz von SMD-Leuchtdioden zu verringern, steht eine bauteilspezifische Eigenheit von SMD- Leuchtdioden entgegen. Eine SMD-Leuchtdiode emittiert Licht nicht gleichmäßig über deren Strahlungsoberfläche, sondern erzeugt einen Lichtkegel, dessen Leuchtintensität an der ausgeleuchteten Basisfläche vom Zentrum zum Rand abnimmt. Beim Einsatz von SMD-Leuchtdioden ist daher der Vorsatz eines Diffusors notwendig, sofern eine gleichmäßige Lichtabstrahlung gefordert bzw. erwünscht ist. Dies führt wiederum zu einer beträchtlichen Bauhöhe im Vergleich zu einer reinen Anordnung mit SMD-Leuchtdioden.

Aufgabe der Erfindung ist es daher, eine Leuchtdiodenanordnung der eingangs genannten Art anzugeben, mit welcher die genannten Nachteile vermieden werden können, und welche eine Verringerung der Bauhöhe bei einer gleichmäßigen Lichtabstrahlung bzw. Ausleuchtung einer Fläche sowie eine Verbesserung der automatisierten Fertigung ermöglicht.

Erfindungsgemäß wird dies dadurch erreicht, dass die Abstrahlfläche der Leuchtdiode der Leiterplatte zugewandt ist, wobei der mit der Abstrahlfläche zusammenwirkende Teil der Leiterplatte in Abstrahlrichtung der Leuchtdiode zumindest bereichsweise transluzent ist. Dadurch kann ohne separat vorzusehenden Diffuser eine gleichmäßige Lichtabstrahlung bzw. Ausleuchtung erreicht werden, wobei die Bauhöhe durch Verzicht des Diffusors wesentlich verringert werden kann. Durch den bevorzugten Einsatz von SMD-Leuchtdioden kann die Höhe des Gesamtaufbaus derart reduziert werden, dass diese nur unwesentlich über der Bauhöbe einer mit SMD- Komponenten bestückten Leiterplatte liegt. Tatsächlich kann ein herkömmlicher Aufbau mit einer Höhe von 2 bis 3 cm auf wenige Millimeter reduziert werden. Weiters kann durch Verwendung von SMD- Komponenten die Fertigung weitestgehend automatisiert werden und die Störanfälligkeit eines derartigen Aufbaus durch Minimierung der zwischen den Komponenten liegenden Leiterstrecken verringert werden. Unter transluzent ist ein zumindest teilweise lichtdurchlässiger bzw. durchscheinbarer Teil zu verstehen. Dieser Teil kann durch seine Materialeigenschaften lichtdurchlässig sein, etwa bei Verwendung von glasfaserverstärkten Leiterplatten. Es kann aber auch vorgesehen sein in ein lichtundurchlässiges Material eine Öffnung einzubringen, welche dann ebenfalls wenigstens transluzent ist.

In Weiterführung der Erfindung kann vorgesehen sein, dass der mit der Abstrahlfläche zusammenwirkende Teil der Leiterplatte als Durchgangsöffnung ausgeführt ist, und an der der Leuchtdiode abgewandten Oberfläche der Leiterplatte wenigstens eine weitere Leiterplatte angeordnet ist, welche wenigstens in dem an die Durchgangsöffnung angrenzenden Bereich zumindest bereichsweise transluzent ausgeführt ist. Dadurch kann auf einfache Weise die Größe der ausgeleuchteten Fläche festgelegt werden. Um eine größere ausgeleuchtete Fläche zu realisieren, kann durch Zwischenfügen einer oder mehrerer Leiterplatten mit Durchgangsöffnungen der Abstand LED - transluzente Oberfläche vergrößert werden.

In diesem Zusammenhang kann in Weiterfiihrung der Erfindung vorgesehen sein, dass der der Abstrahlfläche und/oder der Durchgangsöffnung zugewandte Teil wenigstens einer Leiterplatte einen Hohlraum umfasst, welcher vorzugsweise als Sackloch ausgeführt ist. Dadurch kann ebenfalls die ausgeleuchtete Fläche vergrößert werden, bzw. die Leuchtkraft und die Helligkeit durch Materialabtrag am Träger erhöht werden.

Gemäß einer weiteren Ausführungsform der Erfindung kann vorgesehen sein, dass in der wenigstens einen Durchgangsöffnung und/oder in dem Sackloch, zumindest teilweise transluzentes Material angeordnet ist. Dadurch kann auch bei Verwendung einer Leiterplatte aus an sich nicht transluzentem Material ein transluzenter Bereich gebildet werden. Dadurch können beispielsweise auch Leiterplatten aus Hartpapier zum Einsatz kommen. Beim Vorsehen eines Sackloches ist vorzugsweise vorgesehen ein Leiterplattenmaterial zu wählen, welches lichtdurchlässig ist, etwa glasfaserverstärkte Epoxidharzplatten (ohne Lötstopplack). Es kann jedoch auch vorgesehen sein das Sackloch durch Einbringen einer Durchgangsöffnung in ein an sich lichtundurchlässiges Material, wie z.B. Hartpapier, Kunststoff oder Keramik, und anschließendem bereichsweisen Wiederauffüllen der Durchgangsöffnung mit einem lichtdurchlässigen, transluzenten Material, wie etwa einem Klebstoff, einem Lack, einem Kunstharz oder einem Glas bzw. glasartigen Material zu bilden. Gemäß wieder einer anderen Ausführungsform der Erfindung kann vorgesehen sein, dass der Querschnitt der Durchgangsöffnung größer und/oder gleich dem Querschnitt der Abstrahlfläche und/oder eines strahlungsemittierenden Bereichs der Leuchtdiode ist. Dadurch wird erreicht, dass sämtliche von der Leuchtdiode emittierte Strahlung zu der transluzenten Oberfläche gelangt.

Eine Variante der Erfindung kann darin bestehen, dass die Durchgangsöffnung bzw. das Sackloch - von der Abstrahlfläche zu der der Leuchtdiode abgewandten Oberfläche der Leiterplatte gesehen - sich konisch erweiternd ausgebildet ist. Dadurch folgt die Form der Ausnehmung dem Strahlengang der Leuchtdiode.

In weiterer Ausgestaltung der Erfindung kann vorgesehen sein, dass der Querschnitt des Sacklochs größer und/oder gleich dem Querschnitt der wenigstens einen Durchtrittsöffnung und/oder dass der Querschnitt des Sacklochs größer und/oder gleich der Abstrahlfläche und/oder des strahlungsemittierenden Bereichs der Leuchtdiode ist. Dadurch wird ebenfalls erreicht, dass sämtliche von der Leuchtdiode emittierte Strahlung zu der transluzenten Oberfläche gelangt.

In Weiterbildung der Erfindung kann vorgesehen sein, dass eine Mantelfläche wenigstens einer Durchgangsöffnung und/oder des Sackloches die von der Leuchtdiode abgestrahlte Strahlung reflektierend ausgebildet, vorzugsweise verspiegelt, ist. Dadurch wird verhindert, dass die Seitenwände der Durchgangsöffnung Strahlung absorbieren und dadurch die Lichtausbeute verringern. Diese Reflexionsschicht kann bevorzugt durch direktes Aufbringen einer dünnen metallischen Schicht auf der Mantelfläche der Durchgangsöffnung und/oder der Sacklochwand erfolgen. Eine andere bevorzugte Art der Verspiegelung kann durch Einsetzen eines Metallringes bzw. eines auf der Innenseite metallisierten Kunststoff- oder Glasringes erfolgen. Letztere haben den Vorteil, dass bei Verwendung von Multilayerleiterplatten kein Kurzschluss zwischen den einzelnen leitenden Schichten erzeugt werden kann.

Eine andere mögliche Ausführungsform kann darin bestehen, dass die Mantelfläche wenigstens bereichsweise als Kegelmantelfläche, insbesondere als sich erweiternde und verjüngende Doppelkegelmantelfläche, ausgeführt ist. Dadurch ist es möglich, vor allem bei verspiegelten Mantelflächen, die Mantelflächen derart zu gestallten, dass auch das seitlich gegen die Mantelfläche abgestrahlte Licht durch teilweise mehrfacher Reflexion auf die auszuleuchtende Fläche trifft.

In Weiterführung der Erfindung kann vorgesehen sein, dass an einem mit der Leuchtdiode zusammenwirkenden Teil, vorzugsweise im Bereich einer planen Seite, der Leiterplatte wenigstens ein graphisches Symbol und/oder Schriftzeichen in Abstrahlrichtung der wenigstens einen Leuchtdiode angeordnet ist. Dadurch kann auf einfache Weise ein beleuchtetes Symbol realisiert werden.

In diesem Zusammenhang kann in Weiterführung der Erfindung vorgesehen sein, dass das wenigstens eine graphische Symbol und/oder Schriftzeichen durch teilweises Abtragen einer auf der Leiterplatte angeordneten lichtundurchlässigen Schicht gebildet ist. Dadurch kann das beleuchtete Symbol in einem ohnedies vorgesehenen Arbeitsgang bei der Herstellung der Platine bzw. der Leiterplatte einfach und ohne zusätzliche Kosten hergestellt werden, wobei hohe gestalterische Freiheit besteht.

Gemäß einer weiteren Ausführungsform der Erfindung kann vorgesehen sein, dass die lichtundurchlässige Schicht aus Metall, vorzugsweise aus Kupfer, gebildet ist, und vorzugsweise das wenigstens eine graphische Symbol und/oder Schriftzeichen durch photolithographische Strukturierung der Metallschicht und anschließendem teilweisen Abtragen durch Ätzen freigestellt ist. Dadurch ist das dadurch gebildete Symbol elektrisch leitfähig und kann für weitere Anwendungen verwendet werden.

Gemäß wieder einer anderen Ausführungsform der Erfindung kann vorgesehen sein, dass das graphische Symbol und/oder Schriftzeichen umgebende bzw. ausbildende Metall eine sensitive Metalloberfläche für ein Betätigungselement aufweist. Dadurch kann ohne zusätzliche Bauhöhe ein Höchstmaß an Integration erreicht werden. Diese spezielle Ausgestaltung der Symbolanzeige bedingt das Freistellen einer, definierten Fläche dieser Metall- oder Kupferschicht, aus welcher Fläche das Symbol durch teilweises Abtragen derselben geschaffen wurde.

Eine Variante der Erfindung kann darin bestehen, dass die sensitive Metalloberfläche von einer elektrisch isolierenden Fläche umrandet ist, welche vorzugsweise dünn und linienartig ist. Dadurch ist die sensitive Oberfläche räumlich exakt von der eventuell leitenden Umgebung getrennt, was störende Umgebungseinflüsse ausschließt bzw. minimiert.

In weiterer Ausgestaltung der Erfindung kann vorgesehen sein, dass die das graphische Symbol und/oder Schriftzeichen umgebende, elektrisch isolierende Fläche lichtundurchlässig, vorzugsweise lichtundurchlässig beschichtet, ist. Dadurch ist es möglich die Größe der das Schriftzeichen umgebenden elektrisch isolierenden Fläche entsprechend den elektrischen Erfordernissen auszuführen, ohne dass dadurch eine zu große Fläche beleuchtet würde.

In Weiterbildung der Erfindung kann vorgesehen sein, dass zumindest eine der Leiterplatten als Multilayerplatine ausgeführt ist. Dadurch Verwendung einer Multilayerplatine ist eine besonders rationelle Fertigung einer erfindungsgemäßen Leuchtdiodenanordnung möglich.

Eine andere mögliche Ausführungsform kann darin bestehen, dass die Multilayerplatine in Abstrahlrichtung der wenigstens einen Leuchtdiode wenigstens einen Hohlraum mit vorgebbaren Dimensionen aufweist, welcher durch eine Durchgangsöffnung in wenigstens einer der die Multilayerplatine bildenden Einzelschichten gebildet ist. Dadurch ist es möglich einen Bereich mit vorgebaren transluzenten Eigenschaften in einer Leiterplatte von großer Dicke zu schaffen, welche plane Oberflächen aufweist.

Gemäß wieder einer anderen Ausmhrungsform der Erfindung kann vorgesehen sein, dass das wenigstens eine, graphische Symbol und/oder Schriftzeichen in Abstrahlrichtung der wenigstens einen Leuchtdiode, in einem, entsprechend strukturierten Innenlayer der Multilayerplatine ausgebildet ist. Dadurch kann die Anordnung des Symbols bei der automatischen Fertigung der Mutilayerplatine mitgefertigt werden und beansprucht keinen weiteren Herstellungsvorgang.

Die Erfindung betrifft weiters eine Leuchtanzeige mit einer Leuchtdiodenanordnung gemäß einer der vorstehend beschriebenen Ausführungen. Dadurch können die Vorteile einer erfindungsgemäßen Leuchtdiodenanordnung bei Leuchtanzeigen angewendet werden.

Im Speziellen sind LED beleuchtete Displays bzw. Funktionsanzeigen für Keramikkochfelder sehr gut geeignet. Es ist ein Keramikkochfeld mit Leuchtanzeigesymbolen bekannt, wobei diese direkt unter dem Keramikkochfeld montiert sind. Die Symboldarstellung kann dabei durch eine Schattenmaske, welche direkt auf das Leuchtelement aufgebracht ist, oder durch das Aufbringen einer lichtundurchlässigen Schicht auf der Kochfeldunterseite, welche direkt über dem Leuchtelement unterbrochen ist, gelöst sein.

Die Erfindung betrifft weiters ein Glaskeramikkochfeld mit einer Leuchtdiodenanordnung gemäß einer der vorstehend beschriebenen Ausführungen und/oder einer erfindungsgemäßen Leuchtanzeige. Dadurch können die besonderen Vorteile die sich durch eine erfindungsgemäße Leuchtdiodenanordnung sowie durch eine erfindungsgenläße Leuchtanzeige ergeben auch auf den besonderen Anwendungsfall der Beleuchtung eines Keramikkochfeldes erstreckt werden.

Die Erfindung wird unter Bezugnahme auf die beigeschlossenen Zeichnungen, in welchen besonders bevorzugte Ausführungsformen dargestellt sind, näher beschrieben. Dabei zeigt:
Fig. 1 eine erste Ausführungsform einer Leuchtdiodenanordnung in Untersicht;
Fig. 2 eine Leuchtdiodenanordnung gemäß Fig. 1 im Aufriss;
Fig. 3 eine zweite Ausführungsform einer Leuchtdiodenanordnung in Untersicht;
Fig. 4 eine Leuchtdiodenanordnung gemäß Fig. 3 im Aufriss;
Fig. 5 eine dritte Ausführungsform einer Leuchtdiodenanordnung in Untersieht;
Fig. 6 eine Leuchtdiodenanordnung gemäß Fig. 5 im Aufriss;
Fig. 7 eine vierte Ausführungsform einer Leuchtdiodenanordnung im Aufriss;
Fig. 8 eine fünfte Ausführungsform einer Leuchtdiodenanordnung im Aufriss;
Fig. 9 eine sechste Ausführungsform einer Leuchtdiodenanordnung im Aufriss;
Fig. 10 eine siebente Ausführungsform einer Leuchtdiodenanordnung im Aufriss;
Fig. 11 eine achte Ausführungsform einer Leuchtdiodenanordnung im Grundriss; und
Fig. 12 eine neunte Ausführungsform einer Leuchtdiodenanordnung im Aufriss.

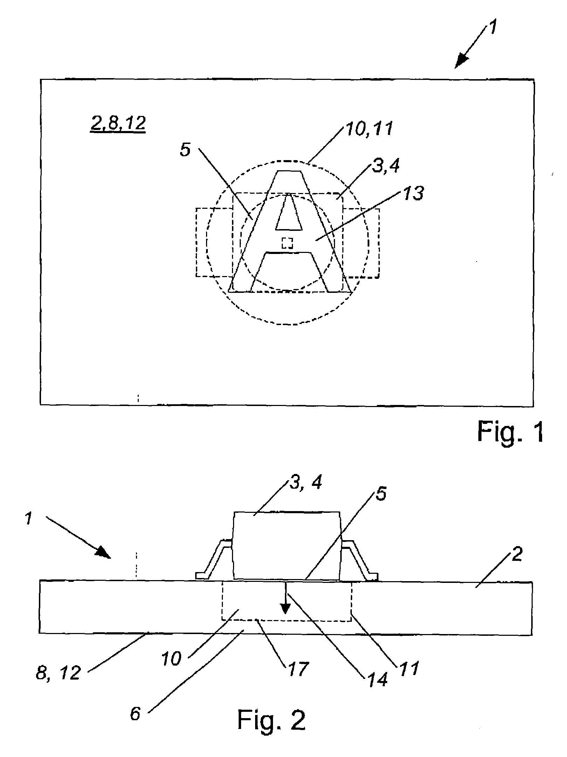

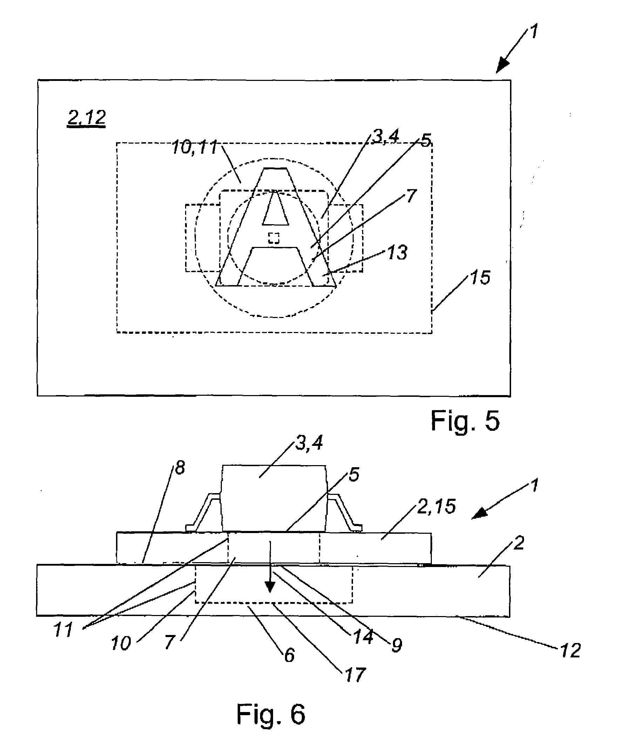

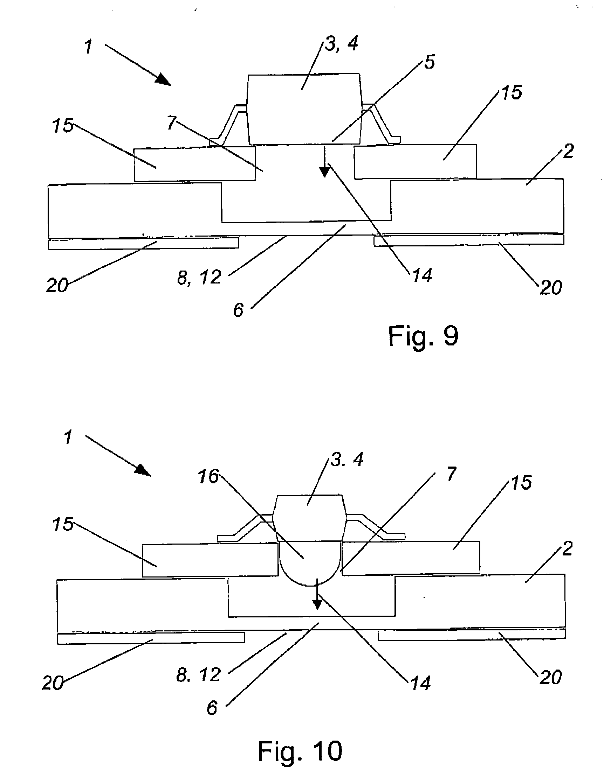

Die Fig. 1 bis 12 zeigen besonders bevorzugte Ausführungsformen einer Leuchtdiodenanordnung 1 umfassend wenigstens eine auf einer Leiterplatte 2, vorzugsweise auf Basis von Kunstharz und Glasfasern, angeordnete und kontaktierte Leuchtdiode 3, vorzugsweise wenigstens eine SMD-Leuchtdiode 4, wobei die Abstrahlfläche 5 der Leuchtdiode 3 der Leiterplatte 2 zugewandt ist, wobei der mit der Abstrahlfläche 5 zusammenwirkende Teil 6 der Leiterplatte 2 in Abstrahlrichtung der Leuchtdiode 3 zumindest bereichsweise transluzent ist.

Der zumindest bereichsweise transluzente Teil 6 der Leiterplatte 2 ist dabei wenigstens bereichsweise durchscheind bzw. lichtdurchlässig ausgeführt.

Die Fig. 1 und 2 zeigen eine erste besonders bevorzugte Ausführungsform einer erfindungsgemäßen Leuchtdiodenanordnung 1 im Grund- und Aufriss. Eine.Leuchtdiode 3, im weiteren gemäß der international üblichen Abkürzung einfach als LED 3 (für light emitting diode) bezeichnet, ist dabei auf einer Leiterplatte 2 angeordnet, daher mit dieser fest verbunden und leitend kontaktiert. Die LED 3 weist wenigstens eine Abstrahlfläche 5 bzw. einen strahlungsemittierenden Bereich auf, durch welche bzw. von der Strahlung emittiert wird. LEDs 3 strahlen hauptsächlich in eine Richtung, wobei diese, sowie eine allfällige Bündelung bzw. Streuung durch geeignete Wahl eines Vorsatzes 16, etwa einer Abdeckung bzw. eines optischen Systems beeinflusst werden kann. Erfindungsgemäß kann vorgesehen sein, die erfindungsgemäße Leuchtdiodenanordnung 1 auf alle Arten von LEDs 3 anzuwenden, daher auf LEDs 3 jeder Größenordnung sowie auf LEDs 3, welche Strahlung der unterschiedlichsten Wellenlänge (von Infrarot bis Ultraviolett) emittieren. Besonders bevorzugt ist der Einsatz in Verbindung mit sog. SMD- LEDs 4, wobei SMD die allgemein übliche technische Abkürzung für surface-mounted device, daher für oberflächenmontiertes Bauelement ist, welche Licht im Bereich des sichtbaren Spektrums, vorzugsweise im Bereich von Rot bis Orange, abstrahlen.

Die LED 3 kann gemäß jedem technisch bekannten Verfahren auf der Leiterplatte 2 angeordnet, fixiert und kontaktiert werden, wobei eine automatische Bestückung sowie eine Verlötung in einem Schwalllötbad als besonders bevorzugt vorgesehen ist.

Die LED 3 gemäß Fig. 1 und 2 ist derart auf der Leiterplatte 2 montiert, dass diese mit deren Abstrahlfläche 5 direkt der Leiterplatte 2 zugewandt ist. Die LED 3 strahlt daher auf bzw. in die Leiterplatte 2. Es ist vorgesehen, dass die Leiterplatte 2 zumindest in diesem von der LED 3 bestrahlten Bereich transluzent, daher durchscheinend und/oder durchsichtig, ist. Unter transluzent ist ein zumindest teilweise lichtdurchlässiger bzw. durchscheinbarer Teil zu verstehen. Dieser Teil 6 kann durch seine Materialeigenschaften lichtdurchlässig sein, etwa bei Verwendung von glasfaserverstärkten Leiterplatten, von welcher eine eventuell vorhandene lichtunduichlässige Schicht 20, wie zum Beispiel der Lötstopplack entfernt ist. Es kann aber auch vorgesehen sein in ein lichtundurchlässiges Material eine Öffnung einzubringen, welche dann ebenfalls wenigstens transluzent ist. Dadurch, dass die LED 3 nicht direkt sichtbar ist, sondern durch die Leiterplatte 2 strahlt, wirkt die Leiterplatte 2 als Diffusor, welcher eine, vor allem bei SMD-LEDs 4, ungleichmäßige Lichtabstrahlung der LED 3 homogenisiert und so eine gleichmäßige Abstrahlung emiöglicht.

Die Leiterplatte 2 ist bevorzugt aus den heute bei Leiterplatten 2 üblichen Materialien aufgebaut. Besonders bevorzugt kommen Leiterplatten 2 auf der Basis von Kunstharz (z.B. Epoxidharz) und Glasfasern zum Einsatz, wie diese beispielsweise unter der Bezeichnung FR4 bekannt sind. Es kann aber auch jedes andere als Leiterplatte 2 einsetzbare Material, vor allem die meisten Kunststoffe, zum Einsatz kommen, sofern dieses transluzente Eigenschaften, zumindest bei einer geringen Materialstärke aufweist. Ein besonderer Vorteil bei der Verwendung von glasfaserverstärkten Epoxidharzleiterplatten ist, dass mit diesen eine besonders gute Wirkung als Diffusor erzielt werden kann. Über die Dicke der durchleuchteten Leiterplatte 2 kann auf einfache Weise die Leuchtstärke eingestellt werden.

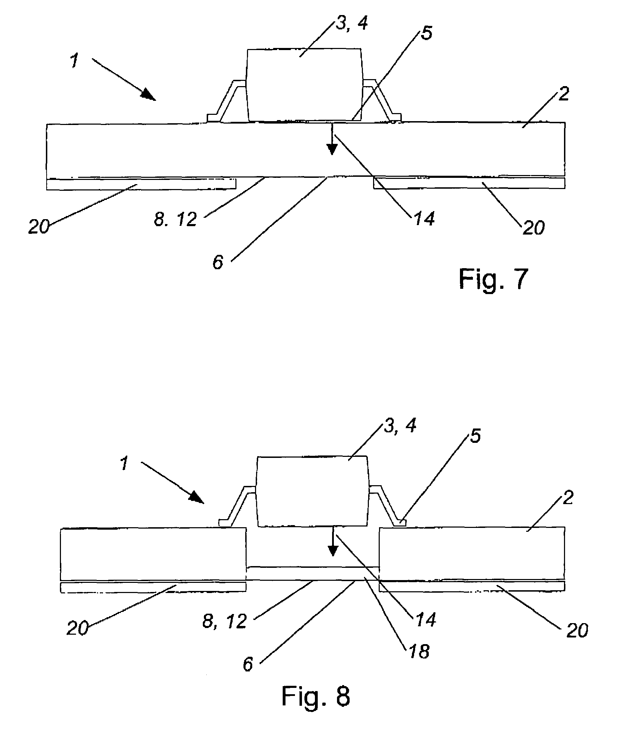

Gemäß einer in Fig. 7 dargestellten besonders einfachen Ausführungsform einer erfindungsgemäßen Leuchtdiodenanordnung 1, kann vorgesehen sein, dass die LED 3 direkt auf eine als plane Fläche ausgeführte Leiterplatte 2 aufgesetzt ist. Dabei weist der durch die Leiterplatte 2 hindurch sichtbare Bereich in etwa die Größe der Abstrahlfläche 5 der LED 3 auf. Mit dieser sehr einfachen Ausführungsform wird ein sehr dünner Aufbau erreicht.

Bei der Ausführungsform gemäß den Figuren 1 und 2 ist die LED 3 auf einer Leiterplatte 2 angeordnet, welche eine Vertiefung in Form eines Sackloches 10 aufweist. Das Sackloch 10 kann dabei jede herstellungstechnisch machbare Form aufweisen. Besonders bevorzugt ist jedoch ein im Wesentlichen zylinderförmiges Sackloch 10. Durch Verringerung der Materialstärke des zu durchleuchtenden Materials wird dadurch die Leuchtdichte erhöht, und durch Vergrößerung des Abstandes von der Abstrahlfläche 5 der LED 3 zur Oberfläche 17 des Sackloches 10 wird die im Sackloch 10 beleuchtete Fläche vergrößert- Dabei kann vorgesehen sein, dass das Sackloch 10 einen Querschnitt aufweist, welcher größer bzw. gleich dem Querschnitt der Abstrahlfläche 5 bzw. des strahlungsemittierenden Bereichs der LED 3 ist. Durch diese Maßnahme kann gewährleistet werden, dass sämtlich abgestrahltes Licht auch die Oberfläche des Sackloches 10 erreicht. Beim Vorsehen eines Sackloches 10 ist vorzugsweise vorgesehen ein Leiterplattenmaterial zu wählen, welches lichtdurchlässig ist, etwa glasfaserverstärkte Epoxidharzplatten ohne Lötstopplack. Es kann jedoch auch vorgesehen sein das Sackloch 10 durch Einbringen einer Durchgangsöffnung 7 in ein an sich lichtundurchlässiges Material, wie etwa Hartpapier, und anschließendem bereichsweisen Wiederauffüllen der Durchgangsöffnung mit einem transluzenten Material 18, wie etwa einem Klebstoff, einem Lack oder einem Kunstharz, zu bilden.

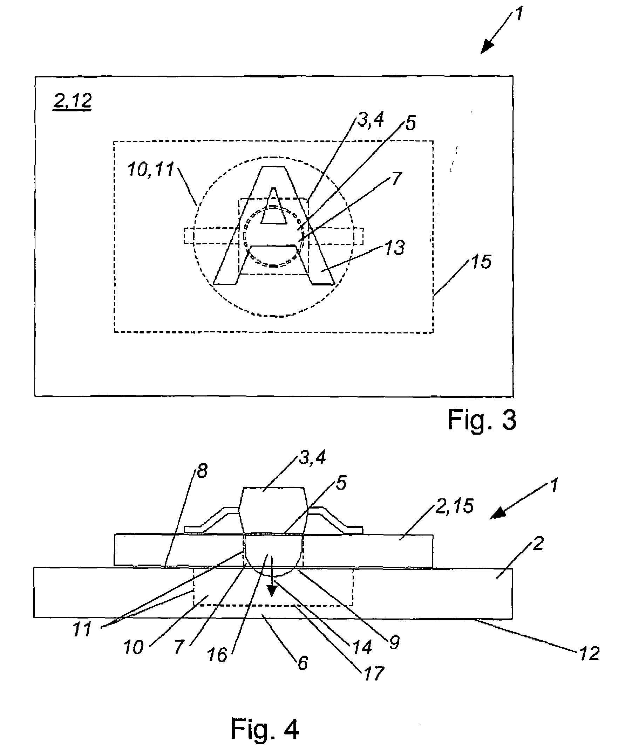

Die Fig. 3 bis 6 sowie 9 und 10 zeigen weitere besonders bevorzugte Ausführungsformen einer erfindungsgemäßen Leuchtdiodenanordnung 1, wobei bei diesen Ausführungsformen vorgesehen ist, dass der der Abstrahlfläche 5 gegenüberliegende Teil 6 der Leiterplatte 2 als Durchgangsδffnung 7 ausgerührt ist, und an der der LED 3 abgewandten Oberfläclie 8 der Leiterplatte 2 wenigstens eine weitere Leiterplatte 15 angrenzt, welche wenigstens in dem an die Durchgangsöffnung 7 angrenzenden Bereich 9 zumindest trainsluzent ausgeführt ist. Dabei ist der mit der Abstrahlfläche 5 zusammenwirkende Teil 6 der Leiterplatte 2 auf der die LED 3 angeordnet ist bei den Ausführungsformen gemäß den Fig. 3 bis 6, durch eine Durchgangsöffnung 7 gebildet. Es kann vorgesehen sein, dass die Durchgangsöffnung 7 einen Querschnitt aufweist, welcher größer bzw. gleich dem Querschnitt der Abstrahlfläche 5 und/oder eines strahlungsemittierenden Bereichs der LED 3 ist.

Durch diese einen Abstandhalter bildende Leiterplatte 2 rückt die LED 3 in Bezug auf die Oberfläche des Sackloches 10 weiter zurück, wodurch bedingt durch die Streuung der LED 3 eine größere Fläche beleuchtet wird. Je nachdem wie groß die beleuchtete Fläche sein soll, können entweder mehrere Leiterplatten 2 mit Durchgangsöffnung 7 hintereinander angeordnet sein, oder eine einzelne dicke Leiterplatte 2. Es kann auch vorgesehen sein, wenigstens eine Leiterplatte 2 mit LED 3 und mit Durchgangsöffnung 7 zusammen mit einer Leiterplatte 2 ohne Sackloch 10, daher mit planer Oberfläche vorzusehen.

Die Ausführungsform gemäß den Fig. 3 und 4 weist eine LED 3 auf, welche einen linsenförmigen optischen Vorsatz 16 aufweist. Dadurch kann der Abstrahlwinkel der LED 3 vergrößert werden, um eine große ausgeleuchtete Fläche zu erreichen, selbst wenn das Anordnen zusätzlicher Leiterplatten 2, welche jeweils eine Durchgangsöffnung 7 aufweisen, nicht möglich ist.

Bevorzugt ist bei den Ausführungen gemäß den Fig. 3 bis 6 sowie 9 und 10 vorgesehen, die Leiterplatte 2 auf der die LED 3 angeordnet ist vorzumontieren und dann wiederum wie einen SMD- Bauteil durch einen Bestückungsautomaten vollaufomatisch zu verarbeiten. Dadurch ist eine weitestgehend automatisierte Fertigung möglich.

Um bei nahe beieinander angeordneten LEDs 3 aufgrund der transluzenten Eigenschaften der Leiterplatte 2 Übersprechen bzw. Überleuchten von einer Anzeige zu einer benachbarten Anzeige zu vermeiden, kann vorgesehen sein, zwischen derartigen, nahe beieinander angeordneten Leuchtdiodenanordnung 1 Einschnitte, Einkerbungen oder Einfräsungen in der Leiterplatte 2 vorzusehen.

Um die Lichtausbeute zu maximieren kann vorgesehen sein, dass eine Mantelfläche 11 wenigstens einer Durchgangsöffnung 7 und/oder des Sackloches 10 zur Reflexion der von der LED 3 abgestrahlten Strahlung ausgebildet, vorzugsweise verspiegelt, ist. Diese Reflexionsschicht kann bevorzugt durch direktes Aufbringen einer dünnen metallischen Schicht auf der Mantelfläche 11 der Durchgangsöffnung 7 und/oder, des Sacklochs 10 erfolgen. Eine andere bevorzugte Art der Verspiegelung kann durch Einsetzen eines, vorzugsweise polierten, Metallringes bzw. eines auf der Innenseite metallisierten Kunststoff-oder Glasringes erfolgen. Letztere haben den Vorteil, dass bei Verwendung von MultilayerLeiterplatten kein Kurzschluss zwischen den einzelnen leitenden Schichten erzeugt werden kann.

Bevorzugt ist vorgesehen erfindungsgemäße Leuchtdiodenanordnungen 1 für Leuchtanzeigen zu verwenden. Es ist daher bevorzugt vorgesehen, dass an einem mit der Leuchtdiode 3 zusammenwirkenden Teil 6, vorzugsweise im Bereich einer planen Seite 12, der Leiterplatte 2 wenigstens ein graphisches Symbol und/oder Schriftzeichen 13 in Abstrahlrichtung 14 der wenigstens einen Leuchtdiode 3 angeordnet ist. Dadurch wird ein direkt auf der Leiterplatte 2 angeordnetes Symbol durch die LED 3 beleuchtet. Die Oberfläche ist durch eine lichtundurchlässige Schicht 20 gebildet. Dies kann sowohl eine Lackschicht, vorzugsweise wie in der Leiterplattenfertigung üblich, ein Lötstopplack oder ein photosensitiver Lack, als auch eine Metallschicht, bevorzugt Kupfer, sein. Dadurch kann das beleuchtete Symbol 13 in einem ohnedies vorgesehenen Arbeitsgang bei der Herstellung der Platine bzw der Leiterplatte 2 einfach und ohne zusätzliche Kosten hergestellt werden, wobei hohe gestalterische Freiheit besteht.

Das Symbol 13 kann dabei auf jede Art auf die Leiterplatte 2 aufgebracht sein, etwa durch Drucken oder Kleben. Ein besonderer Vorteil ergibt sich dadurch, dass das wenigstens eine graphische Symbol und/oder Schriftzeichen 13 durch Abtragen, vorzugsweise durch Ätzen, einer auf der Leiterplatte 2 angeordneten Metalloberfläche, vorzugsweise Kupfer, gebildet ist. Dadurch ist es möglich, in einem Arbeitsgang mit der Herstellung der Leiterplatte 2 das zu veranschaulichende Symbol 13 in dauerhafter, licht- und wärmeresistenter Form auf der Leiterplatte 2 herzustellen.

Bevorzugt wird zuerst, zumindest im Bereich, wo das Symbol 13 vorgesehen ist, eine Kupferschicht auf die Leiterplatte 2 bzw. das die LED 3 beinhaltende Trägermaterial aufgebracht. Das Herausarbeiten des gewählten Symbols 13 kann nunmehr auf zwei bevorzugte Weisen erfolgen. Sind z.B. nur geringe Stückzahlen zu fertigen, kann das Symbol 13 einfach mittels Frästechnik durch teilweises mechanisches Abtragen der Kupferschicht erhalten werden. Die zweite bevorzugte Technik zur Freistellung transluzenter Bereiche auf der der Leuchtdiode 3 abgewandten, vorzugsweise planen, Seite 12 der Leiterplatte 2 bzw. des in diesem Bereich transluzent ausgeführten Trägersubstrates ist die photolithographische Strukturierung der Kupferschicht, welche mittels eines Ätzschritts abgetragen wird.

Es kann auch der Einsatz mit Multilayerplatinen vorgesehen sein, wobei dabei vorgesehen sein kann das Symbol 13 auch in einem entsprechend strukturierten Innenlayer anzuordnen. Berücksichtigt man schon in der Leiterplattenproduktion das hier vorgeschlagene Konzept der Gestaltung und Ausführung von Leuchtanzeigen, ist im Falle von Multilayerplatinen jede erdenkliche geometrische Ausführungsform der Sacklöcher 7 in einfacher, kostengünstiger Weise herstellbar. Produktionstechnisch ist in den die Multilayerplatine ergebenden Einzelschichten, zumindest in jenen welche den inneren Teil der Multilayerplatine bilden, jeweils eine Durchgangsöffnung in definierter Form und Größe vorzusehen, sodass nach dem Assemblieren ein Hohlraum bzw. Sackloch 7 der gewünschten geometrischen Form gebildet wird. Ist die Mantelfläche 11 des so in geeigneter Geometrie ausgeformten Sacklochs 7 verspiegelt, kann durch Reflexion an den Mantelflächen 11 der größte Teil des von der LED 3 einfallenden Lichtes auf das auszuleuchtende Symbol 13 projiziert werden. Ein daraus resultierender Leiterplattenaufbau kann somit erlauben, dass mit nur einer einzigen Leiterplatte 2 alle hier veranschaulichten Ausformungen einer erfindungsgemäßen Leuchtdiodenanordnung 1 realisiert werden können.

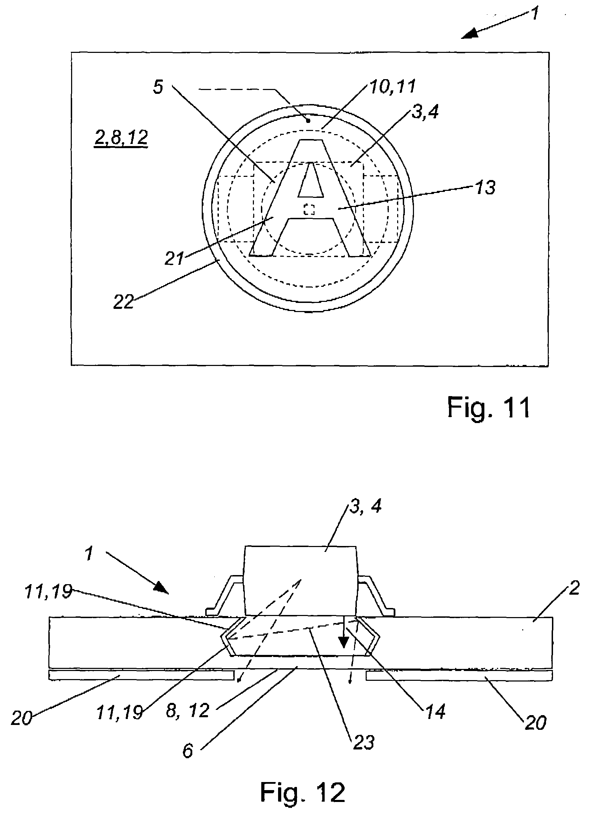

Bei einer Ausführungsform gemäß Fig- 12 kann vorgesehen sein, dass die Mantelfläche 11 wenigstens bereichsweise als Kegelmantelfläche 19, insbesondere als sich erweiternde und verjüngende Doppelkegelmantelfläche, ausgeführt ist. Eine erste Kegelmantelfläche 19 erstreckt sich dabei von der LED 3 ausgehend, konisch erweiternd in der Leiterplatte 2 hinein. An diese erste Kegelmantelfläche 19 grenzt eine zweite Kegelmantelfläche 19, welche in Richtung von der LED 3 ausgehend sich verjüngend ausgeführt ist. Die Kegelmantelflächen 19 sind bevorzugt verspiegelt ausgeführt. In Fig. 12 ist ein möglicher Strahlengang 23 der von der LED 3 emittierten Strahlung dargestellt, wobei deutlich erkennbar ist, dass es bei geeigneter Wahl der Winkel unter denen die Kegelmantelflächen 19 ausgeführt sind, unter Ausnutzung von Mehrfachreflexionen zu einem verstärkten Lichtaustritt an dem transluzenten Teil 6 der Leiterplatte 2 kommt. Dadurch kann bei gleicher Lichtleistung einer LED 3 die Leuchtdichte erhöht werden. Es kann auch ein entsprechend ausgeführter Hohlraum vorgesehen sein. Ein derartiges Sackloch 7 kann besonders einfach bei der Verwendung von Multilayerplatinen hergestellt werden, da dabei jede Art von Sackloch 7 und/oder Hohlraum bereits bei der Herstellung der Multilayerplatine integriert werden kann. Die einzelnen Teile, welche in der Folge zu einer Multilayerplatine zusammengefügt werden, werden mit entsprechend großen und vorzugsweise eine Schräge aufweisenden Löchern versehen, welche beim zusammenfügen zu einer Multilayerplatine eine entsprechende Ausnebmung bilden. Durch Kombination der Leuchtdiodenanordnung 1 mit Betätigungselementen kann eine kombinierte Steuerungs- und Anzeigeanordnung gebildet werden. Bevorzugt kann dabei vorgesehen sein, dass das graphische Symbol und/oder Schriftzeichen 13 als sensitive Oberfläche 21 für ein Betätigungselement ausgebildet ist. Eine derartige sensitive Oberfläche 21 kann etwa für einen kapazitiv wirksamen Sensor einen optischen Sensor oder einen galvanischen Sensor vorgesehen sein. Dabei kann vorgesehen sein, die Flächen des dargestellten Symbols als elektrisch leitfähige zusammenhängende Fläche auszuführen.

Die spezielle Ausgestaltung der Symbolanzeige bedingt das Freistellen einer definierten Fläche dieser Metall- oder Kupferschicht, aus welcher Fläche das Symbol 13 durch teilweises Abtragen derselben geschaffen wurde. Diese Freistellung oder Eingrenzung der sensitiven Fläche 21 wird durch Herausätzen oder Fräsen einer elektrisch isolierenden Fläche 22, vorzugsweise einer dünnen, in sich geschlossenen, linienartig ausgeführten Fläche, z.B. in Form eines Kreises, erreicht, sodass die sensitive Fläche 21 von der restlichen Metall- bzw. Kupferschicht elektrisch abgekoppelt vorliegt. Die Stegbreite dieser elektrisch isolierenden Fläche 22 ist zumindest so groß zu wählen, dass es zwischen den einzelnen Kupferflächen zu keinen Paschen-Entladungen kommt. In der Praxis sind jedoch größere Stegbreiten vorzusehen. Ist es aus designtechnischen Gründen vorgesehen, dass diese die Sensorfläche 21, in welcher das darzustellende Symbol 13 eingearbeitet ist, umrahmende Linie nicht sichtbar ist, ist diese mittels einer lichtundurchlässigen Schicht 20, welche bevorzugt als nicht leitende, nicht-transluzente Lackschicht ausgeführt ist, zu versiegeln. Die Kontaktierung des so erzeugten Sensorpads mit einer Schalteinheit erfolgt mittels einem in (bei MultilayerLeiterplatten) oder durch die Leiterplatte 2 oder das Trägersubstrat hinein oder durchreichenden Metall-Pin.

Eine besonders bevorzugte Anwendung erfindungsgemäßer Leuchtdiodenanordnung 1, Leuchtanzeigen und/oder Steuerungs- und/oder. Anzeigeanordnung sind Keramikkochfelder. Erfindungsgemäße Anordnungen können unter den durchscheinend ausgeführten Glaskeramikkochfeldem angeordnet werden, wobei diese durch deren platzsparenden Aufbau kaum Platz, vor allem kaum Bautiefe beanspruchen.

Weitere bevorzugte Anwendungsgebiete sind Statusanzeigen, etwa in Autos sowie in tragbaren Geräten, welche nur eine geringe Bautiefe zulassen.

Zur Wärmeabfuhr kann weiters ein Kühlkörper, in Form von in die Durchgangsöffnung 7 und/oder das Sackloch 10 hineinragende Kupferstifte vorgesehen sein.

Weitere erfindungsgemäße Ausführugsformen weisen lediglich einen Teil der beschriebenen Merkmale auf, wobei jede Merkmalskombination, insbesondere auch von verschiedenen beschriebenen Ausführungsformen, vorgesehen sein kann.

## Patentansprüche

1. Leuchtdiodenanordnung (1) umfassend wenigstens eine auf einer Leiterplatte (2), vorzugsweise auf Basis von Kunstharz und Glasfasem, angeordnete und kontaktierte Leuchtdiode (3), vorzugsweise wenigstens eine SMD-Leuchtdiode (4), **dadurch gekennzeichnet, dass** die Abstrahlfläche (5) der Leuchtdiode (3) der Leiterplatte (2) zugewandt ist, wobei der mit der Abstrahlfläche (5) zusammenwirkende Teil (6) der Leiterplatte (2) in Abstrahlrichtung der Leuchtdiode (3) zumindest bereichsweise transluzent ist.

2. Leuchtdiodenanordnung (1) nach Anspruch 1, **dadurch gekennzeichnet, dass** der mit der Abstrahlfläche (5) zusammenwirkende Teil (6) der Leiterplatte (2) als Durchgangsöffnung (7) ausgeführt ist, und an der der Leuchtdiode (2) abgewandten Oberfläche (8) der Leiterplatte (2) wenigstens eine weitere Leiterplatte (15) angeordnet ist, welche wenigstens in dem an die Durchgangsöffnung (7) angrenzenden Bereich (9) zumindest bereichsweise transluzent ausgeführt ist.

3. Leuchtdiodenanordnung (1) nach Anspruch 1 oder 2, **dadurch gekennzeichnet, dass** der der Abstrahlfläche (5) und/oder der Durchgangsöffnung (7) zugewandte Teil wenigstens einer Leiterplatte (2) einen Hohlraum umfasst, welcher vorzugsweise als Sackloch (10) ausgeführt ist.

4. Leuchtdiodenanordnung (1) nach Anspruch 3, **dadurch gekennzeichnet, dass** in der wenigstens eine Durchgangsöffnung (7) und/oder in dem Sackloch (10), zumindest teilweise transluzentes Material (18) angeordnet ist.

5. Leuchtdiodenanordnung (1) nach Anspruch 3 oder 4, **dadurch gekennzeichnet, dass** der Querschnitt der Durchgangsöffnung (7) größer und/oder gleich dem Querschnitt der Abstrahlfläche (5) und/oder eines strahlungsemittierenden Bereichs der Leuchtdiode (3) ist.

6. Leuchtdiodenanordnung (1) nach einem der Ansprüche 3 bis 5, **dadurch gekennzeichnet, dass** die Durchgangsöffnung (7) bzw. das Sackloch (10) - von der Abstrahlfläche (5) zu der der Leuchtdiode (2) abgewandten Oberfläche (8) der Leiterplatte (2) gesehen - sich konisch erweiternd ausgebildet ist.

7. Leuchtdiodenanordnung (1) nach einem der Ansprüche 3 bis 6, **dadurch gekennzeichnet, dass** der Querschnitt des Sacklochs (10) größer und/oder gleich dem Querschnitt der wenigstens einen Durchtrittsöfnung (7) und/oder dass der Querschnitt des Sacklochs (10) größer und/oder gleich der Abstrahlfläche (5) und/oder des strahlungsemittierenden Bereichs der Leuchtdiode (3) ist.

8. Leuchtdiodenanordnung (1) nach einem der Ansprüche 3 bis 7, **dadurch gekennzeichnet, dass** eine Mantelfläche (11) wenigstens einer Durchgangsöffnung (7) und/oder des Sackloches (10) die von der Leuchtdiode (3) abgestrahlte Strahlung reflektierend ausgebildet, vorzugsweise verspiegelt, ist.

9. Leuchtdiodenanordnung (1) nach Anspruch 8, **dadurch gekennzeichnet, dass** die Mantelfläche (11) wenigstens bereichsweise als Kegelmantelfläche (19), insbesondere als sich erweiternde und verjüngende Doppelkegelmantelfläche, ausgeführt ist.

10. Leuchtdiodenanordnung (1) nach einem der Ansprüche 1 bis 9, **dadurch gekennzeichnet, dass** an einem mit der Leuchtdiode (3) zusammenwirkenden Teil (6), vorzugsweise im Bereich einer planen Seite (12), der Leiterplatte (2) wenigstens ein graphisches Symbol und/oder Schriftzeichen (13) in Abstrahlrichtung (14) der wenigstens einen Leuchtdiode (3) angeordnet ist.

11. Leuchtdiodenanordnung (1) nach Anspruch 10, **dadurch gekennzeichnet, dass** das wenigstens eine graphische Symbol und/oder Schriftzeichen (13) durch teilweises Abtragen einer auf der Leiterplatte (2) angeordneten lichtundurchlässigen Schicht (20) gebildet ist.

12. Leuchtdiodenanordnung (1) nach Anspruch 11, **dadurch gekennzeichnet, dass** die lichtundurchlässige Schicht (20) aus Metall, vorzugsweise aus Kupfer, gebildet ist, und vorzugsweise das wenigstens eine graphische Symbol und/oder Schriftzeichen (13) durch photolithographische Strukturierung der Metallschicht und anschließendem teilweisen Abtragen durch Ätzen freigestellt ist.

13. Leuchtdiodenanordnung (1) nach Anspruch 12, **dadurch gekennzeichnet, dass** das das graphische Symbol und/oder Schriftzeichen (13) umgebende bzw. ausbildende Metall eine sensitive Metalloberfläche (21) für ein Betätigungselement aufweist.

14. Leuchtdiodenanordnung (1) nach Anspruch 13, **dadurch gekennzeichnet, dass** die sensitive Metalloberfläche (21) von einer elektrisch isolierenden Fläche (22) umrandet ist, welche vorzugsweise dünn und linienartig ist.

15. Leuchtdiodenanordnung (1) nach Anspruch 14, **dadurch gekennzeichnet, dass** die das graphische Symbol und/oder Schriftzeichen (13) umgebende, elektrisch isolierende Fläche (22) lichtundurchlässig, vorzugsweise lichtundurchlässig beschichtet, ist.

16. Leuchtdiodenanordnung (1) nach einem der Ansprüche 1 bis 15, **dadurch gekennzeichnet, dass** zumindest eine der Leiterplatten (2) als Multilayerplatine ausgeführt ist.

17. Leuchtdiodenanordnung (1) nach Anspruch 16, **dadurch gekennzeichnet, dass** die Multilayerplatine in Abstrahlrichtung der wenigstens einen Leuchtdiode (3) wenigstens einen Hohlraum mit vorgebbaren Dimensionen aufweist, welcher durch eine Durchgangsöffnung in wenigstens einer der die Multilayerplatine bildenden Einzelschichten gebildet ist.

18. Leuchtdiodenanordnung (1) nach Anspruch 16 oder 17, **dadurch gekennzeichnet, dass** das wenigstens eine graphische Symbol und/oder Schriftzeichen (13) in Abstrahlrichtung (14) der wenigstens einen Leuchtdiode (3), in einem, entsprechend strukturierten Innenlayer der Multilayerplatine ausgebildet ist.

19. Leuchtanzeige mit einer Leuchtdiodenanordnung (1) gemäß einem der Ansprüche 1 bis 18.

20. Glaskeramikkochfeld mit einer Leuchtdiodenanordnung (1) gemäß einem der Ansprüche 1 bis 18 und/oder einer Leuchtanzeige gemäß Anspruch 19.
